# EUROPEAN PATENT SPECIFICATION

(11) **EP 3 269 215 B1**
(45) Date of publication and mention of the grant of the patent: **22.04.2020**
(21) Application number: 16709767.4
(22) Date of filing: 11.03.2016
(51) Int. Cl.: H05K 3/44, H05K 1/02, H05K 1/05, H05K 3/46

(54) **PRINTED CIRCUIT BOARD AND METHOD MANUFACTURING THE SAME**
LEITERPLATTE UND HERSTELLUNGSVERFAHREN DIESER LEITERPLATTE
CIRCUIT IMPRIMÉ ET PROCÉDÉ DE FABRICATION DE CELUI-CI

(30) Priority: 12.03.2015 DE 102015103674
(43) Date of publication of application: 17.01.2018
(73) Proprietor: AT & S Austria Technologie & Systemtechnik Aktiengesellschaft, 8700 Leoben (AT)
(72) Inventor: MAIER, Markus, 8020 Graz (AT)
(74) Representative: Dilg, Haeusler, Schindelmann Patentanwaltsgesellschaft mbH
(86) International application number: PCT/EP2016/055248
(87) International publication number: WO 2016/142505

(56) References cited:
- EP-A1- 1 561 368
- EP-A2- 1 154 480
- US-A1- 2003 011 070
- US-A1- 2009 084 596
- US-A1- 2009 242 248

## Description

### Field of the invention

The present invention generally relates to the technical field of electronic components. In particular, the present invention relates to a printed circuit board for integrating electronic circuitry. The present invention further relates to a method of manufacturing a printed circuit board. Moreover, the invention relates to an electronic component comprising electronic circuitry.

### Art Background

Printed circuit boards (PCB) are widely used in the field of semiconductor devices and packages as a substrate or carrier for forming electronic modules or packages including integrated circuits. Originally such PBCs comprise a dielectric carrier onto which conductive paths are formed by lithography processes. In the meantime more sophisticated PBCs are known including a stack of a plurality of layers. For example, one type of PCB comprises a stack of three conductive layers having arranged between the three conductive layers two dielectric layers electrically isolating the conductive layers. In particular, such a PCB comprises a metallic core layer, which may function as electrical ground and/or as a heat sink discharging heat generated from electronic circuits arranged on the PCB. Furthermore, a dielectric layer is arranged on each main surface of the metallic core layer and a (patterned) conductive layer on each dielectric layer. For electrically connecting the two outer conductive layers and/or thermally connecting the same vias may be formed through the stack electrically connecting conductive paths of one conductive layer to the metallic core layer and/or to conductive paths of the other conductive layer. However, the methods of manufacturing such stacked PCB may be complex.

The prior art comprises the documents EP-A1-1561368, EP-A2-1154480 and US-A1-2003/011070.

### Summary

While there are already known printed circuit boards (PCBs) having a stacked multilayer structure there may be a need for alternative PCBs and methods of manufacturing the same, wherein the PCBs may be manufactured in a less complex process.

This need may be met by the subject matter according to the independent claims. Advantageous embodiments of the present invention are described by the dependent claims.

According to an exemplary aspect a printed circuit board is provided which comprises a core layer of a conductive metal having a thickness between 30 micrometer and 120 micrometer, an upper dielectric layer and a lower dielectric layer sandwiching the core layer; an upper conductive layer arranged above the upper dielectric layer and a lower conductive layer arranged below the lower dielectric layer; at least one through via passing from the upper conductive layer to the lower conductive layer and filled at least partially with the dielectric material of the upper and/or lower dielectric layer; and at least one and blind via, connecting the upper conductive layer with the core layer.

In particular, the thickness of the core layer may be in the range of 50 micrometer to 120 micrometer, e.g. in the range of 75 micrometer to 120 micrometer or 75 micrometer to 100 micrometer, e.g. (about) 100 micrometer. An upper limit of about 100 micrometer may be sufficient since a higher thickness may not improve discharging heat any more but may only provide additional (material) costs. It should be noted that the core layer may be off center, e.g. due to the fact that the two dielectric layer and/or conductive layers may have different thicknesses. However, preferably the core layer is (substantially) in central position. The use of a core layer having a thickness in such a range may particularly useful or advantageous, since thus a thickness may still enable a sufficient rigidity or stiffness of the multilayer structure to handle the same relatively easy while still enable it that a via formed in the core layer may be filled "automatically" during a later process step, e.g. during a lamination process or the like. In particular, the through vias may be formed by mechanically drilling or by using a laser.

It should be noted that the term "filled with" may be distinguished from the term "plugged with". While plugged with may be interpreted as stuffed by a separate process including the provision and use of a plug material, the term "filled" may be interpreted that during a process step a material already present (e.g. the dielectric material of the dielectric layer) flows into a via and filling the same. Thus, while a plugging process may be based on the use of an extra material a filling step may go without the use of applying or using an extra material. In particular, the "filling" may even be a side effect of another step, e.g. the forming or processing of dielectric layers above and below a central core layer may at the same time provide an (at least partially) filling of holes or vias arranged in the core layer. Thus, the use of a "filling process" instead of a plugging step may save one process step (the applying of the plug) during manufacturing or processing and thus may simplify the whole process. This may in particularly be true in the case of a low thickness of the core layer (corresponding to a relatively short via) and/or in case of a via having a relative low diameter, since then it may be eased or facilitated that the via may be fully filled during a processing step by material flowing into the via.

It should be noted that the upper and/or lower dielectric layer may be formed on the core layer by a lamination process or laminating step. In particular, before the lamination step an etching step may be performed to roughen a surface of the core layer. Thus, the dielectric layer(s) may keep or hold better to the core layer and the danger of delamination may be reduced. The dielectric layers may have a thickness in the range of 50 micrometer to 150 micrometer, in particular in the range of 60 micrometer to 130 micrometer. The thickness may be chosen depending on the thickness of the core layer.

It should be noted that the blind via(s) or recess(es) do not form a through connection from the upper conductive layer to the lower conductive layer but only form a (thermal) connection to the core layer. An electrical connection from the (circuitry optionally formed on the upper/lower conductive layer) upper to the lower conductive layer may be formed by the through via in particular of an electrically conductive material deposited or present in the (radially central part) through via. However, it should be noted that the electrically conductive material may not completely fill the radially central part. For example, the electrically conductive material may only cover an isolation layer formed in a through hole which was formed for providing a path for the through via. The (radially) central part or portion may be unfilled or may be filled with another material. Thus, an electrically conductive connection or path between the upper conductive layer and the lower conductive layer may be formed only by a (thin) cover or layer of the electrically conductive material in the through via.

In particular, an electronic component, chip, die, or electronic circuitry and/or a passive (electric) component (like resistance, coil, capacitor) may be embedded or integrated in the printed circuit board as well.

According to another exemplary aspect an electronic component is provided which comprises a printed circuit board according to an exemplary aspect; and an electronic circuitry arranged on the printed circuit board.

The electronic circuitry may be attached to the PCB by any suitable method, e.g. may be bonded, adhered or soldered. In particular, attachment may be in such a way that an electric and/or thermal conductive connection between the electronic circuitry and the PCB is achieved. The electronic circuitry may be an integrated chip or die or the like.

In particular, the electronic circuitry may form at least one electronic component which is selected out of the group consisting of: active electronic component; passive electronic component; data storage; filter; integrated circuit or chip; signal processing component; power management component; optoelectrical interface (element); voltage converter; cryptographic component; capacity or capacitor; resistance or resistor; sending unit; receiving unit; transceiving unit (or transceiver); electro-mechanical converter; inductivity or inductor; switch (e.g. transistor); microelectromechanical system; battery; camera; and antenna.

According to another exemplary aspect a method of manufacturing a printed circuit board is provided, wherein the method comprises providing a metallic core layer having a thickness between 30 micrometer and 120 micrometer and having arranged thereon at least one dielectric layer on a main surface of the metallic core layer; forming a through hole through the metallic core layer; forming a second dielectric layer on a second main surface opposite to the upper main surface of the metallic core layer; and at least partially filling the through hole with material of the second dielectric layer.

In particular, the through hole may be formed by a mechanical drilling step. However, preferably the through hole may be formed by an etching process. In particular, it should be noted that the forming of the second dielectric layer and the (partially) filling of the through hole may be a single process step. For example, some material of the second dielectric layer may flow into the formed through hole and may cover sidewalls of the core layer which sidewalls forming or defining the through hole. In particular, the through hole extends through the core layer (i.e. from one main surface to the opposite main surface), while the at least one dielectric layer arranged on one of the main surfaces may not be completely opened. Thus, the through hole may (while passing through the whole or complete core layer) be rather a recess when taking into account the at least one dielectric layer as well. Optionally a plurality of through holes and/or through vias may be formed.

It should be noted that the through hole may be formed either before or after the second dielectric layer is formed, e.g. by a lamination process, onto the metallic core layer. In case the through hole is formed beforehand the through hole may be filled during the formation process of the second dielectric layer. For example, during the lamination process forming the second dielectric layer some of the material of the lamination layer may flow into the through hole and may (partially) fill the same. Thus, no addition step may be necessary to plug additional material, e.g. dielectric paste or the like, into the through hole while an isolation layer covering the core layer in the region or portion the through hole may be (automatically) formed. Thus, the manufacturing process may be simplified. During the lamination process (also providing for the partially filling) also some thickness or surface irregularities may be leveled.

It should be noted that while the thickness of the metallic core layer is rather thin compared to known PCB manufacturing processes due to an already formed dielectric layer on one side it may be rigid enough to be handled.

In the context of the present application, a "printed circuit board" may particularly denote a plate shaped body which has a metallic core layer and comprising at least two further electrically conductive layers. Such a printed circuit board (PCB) may serve as a basis for mounting electronic members thereon and/or therein and serves both as a mechanical support platform and as an electrically wiring arrangement comprising appropriate conductor paths for electrically and/or for thermally connecting the electronic component being arranged within the cavity. The "printed circuit board" may also be denoted a "conductor board" or simply a "circuit board". The "printed circuit board" may be a mechanically stiff structure, which provides a more or less rigid support for the electronic component. Alternatively, the "printed circuit board" may comprise a certain flexibility. This flexibility may be given over the whole surface area of the "printed circuit board" or may be given only within predetermined surface portions of the "printed circuit board". In particular, a PCB may be a so called "finished PCB". This means that for producing the described electronic assembly the PCB or the PCBs being used have already finished their production and represents respectively represent a semi-finished part for the production of the described electronic assembly. Specifically, the PCB or the PCBs being used have already completed their PCB production process where an electrically conductive structure or layer has been applied. Such a production process may also include a structuring and/or patterning of the electrically conductive layer, which structuring and/or patterning is carried out in a known and suitable manner in order to provide appropriate conductor paths and/or connection pads.

Using such a (multilayer) PCB may provide the advantage that the electric wiring connection to and from the electronic component can be extended from the two dimensional surface of a single layer PCB at least partially into the third dimension perpendicular to the PCB surface. Thereby, if required, a highly sophisticated electric connection or wiring pattern may be realized. For connecting different regions, conductor paths and/or connection pads being located one upon the other in different metallic planes metallic studs and/or through holes called vias may be used.

A dielectric layer may be made from different materials such as e.g. an epoxy resin together with fiber glass reinforcement. With respect to fire retardant (FR) such a material may be called FR-4 material.

In the following further exemplary embodiments of the PCB will be explained. However, the features of the specific embodiments may also be combined with the method of manufacturing the PCB.

According to an exemplary embodiment of the printed circuit board the dielectric material is selected out of the group consisting of: FR-4 materials; resin; bismaleimide triazine resin; cyanate ester; glass; glass fibers; prepreg materials; polyimide; liquid crystal polymers; epoxy based build-up film; ceramic material; Teflon; metal oxide; and a combination thereof.

FR-4 is a grade designation assigned to glass-reinforced epoxy laminate sheets, tubes, rods and printed circuit boards (PCB). FR-4 is a composite material composed of woven fiberglass cloth with an epoxy resin binder that is flame resistant (*self-extinguishing*)*.* Thereby "FR" stands for flame retardant, and denotes that safety of flammability of FR-4 is in compliance with the standard UL94V-0. FR-4 is created from the constituent materials (epoxy resin, woven glass fabric reinforcement, brominated flame retardant, etc.)

According to an exemplary embodiment of the printed circuit board a diameter of the at least one through via is below 500 micrometer.

In particular, the diameter may be in the range of 125 micrometer to 300 micrometer, e.g. in the range of 200 micrometer to 250 micrometer. However, it should be noted that according to the intended application the diameter may be even larger or smaller than the above given boundaries. Preferably, through hole(s) for the through via(s) may be formed by mechanically drilling. In the described range mechanically drilling may be a suitable and/or efficient way to form the through hole(s). In particular, it may be possible to provide through hole(s) having (substantially) perpendicular side walls when these are formed by mechanically drilling which may be more difficulty or complicated to be achieved when using a laser or etching agent.

According to an exemplary embodiment the printed circuit board further comprises an upper outer conductive layer and a lower outer conductive layer, wherein the upper outer conductive layer is arranged above the upper conductive layer and the lower outer conductive layer is arranged below the lower conductive layer.

Thus, a five (conductive) layer PCB may be formed enabling the implementing or integrating of additional circuitry. In particular, it should be noted that of course more than five (conductive) layers may be provided. It should further be noted that of course one or several additional dielectric layers may be arranged between the upper conductive layer and the upper outer conductive layer and/or between the lower conductive layer and the lower outer conductive layer may be provided. In particular, a multilayer stack may be provided having an alternating sequence of (electrically) conductive layers and dielectric layers.

According to an exemplary embodiment of the printed circuit board in the through via a conductive hole wall is formed by an electrically conductive material surrounded by the filled dielectric material.

In particular, the conductive hole wall may completely fill the (radially) central portion or may only form a conductive cover on sidewalls of a corresponding through hole, i.e. the conductive hole wall may not fill the center of the through via. In case the center is completely filled with the conductive material of the conductive hole wall the conductive path formed by the conductive "hole wall" may have a diameter in the range of 50 micrometer to 200 micrometer, preferably in the range of 75 micrometer to 125 micrometer. For forming the conductive hole wall a through hole may be formed in the dielectric material filling the through via. For example, the through hole may be formed by using laser. Alternatively, the through hole may be drilled mechanically (depth drill).

However, it is also possible that the filling (by flowing of dielectric material into the original through hole forming the through via) may only be partially so that the through via still comprises a (radially) central core not filled by dielectric material. In this case it may be possible to omit an extra step for forming the through hole and to form the conductive hole wall by just covering the dielectric material filling the original through hole by a layer of conductive material.

According to an exemplary embodiment of the printed circuit board the at least one blind via has a diameter in the range of 10 micrometer to 150 micrometer.

In particular, the diameter in the range of 15 micrometer to 100 micrometer, preferably in the range of 20 micrometer to 75 micrometer, e.g. about 50 micrometer. In particular, the at least one blind via is formed by using a laser. It should be noted that in the blind vias a thermally conductive material, e.g. copper, aluminum or the like, may be deposited, e.g. by filling. The blind via(s) may particularly be used to thermally connect the upper and/or lower conductive layer to the core layer which may form a heat sink or a path for discharging heat generated by circuitry formed in or on the upper/lower conductive layer(s). Furthermore, the blind via(s) may as well function as an electrically connection, e.g. to ground potential, in case the core layer is connected to ground. It should be noted that sidewalls of a hole formed for the blind via(s) may have an inclined shape or (truncated) conical shape. Such a shape may particularly formed when a laser and/or etching agent is used to form the blind holes.

According to an exemplary embodiment of the printed circuit board the printed circuit board further comprising a second blind via connecting the lower conductive layer with the core layer.

In should be noted that of course a plurality of blind vias may be formed in the PCB each connecting the upper conductive layer or the lower conductive layer with the core layer.

In the following further exemplary embodiments of the method of manufacturing a PCB will be explained. However, the features of the specific embodiments may also be combined with the embodiments of the PCB.

According to an exemplary embodiment the method further comprises forming the metallic core layer having the at least one dielectric layer arranged thereon by removing an auxiliary layer.

For example, a commonly used multilayer stack comprising a metallic core and two dielectric layers arranged thereon (one on every main surface of the metallic core) may be used and one of the two dielectric layers may be removed, e.g. by etching, polishing or the like. In the same way a commonly used multilayer stack comprising a central dielectric layer covered on both sides by a conductive (e.g. copper) layer may be usable by removing one of the conductive layers in advance. Thus, it may be possible to avoid handling of a single core layer of a thickness which is too low to handle it in a safe way.

According to an exemplary embodiment the method further comprises forming a first conductive layer on the first dielectric layer and a second conductive layer on the second dielectric layer.

In particular, the first and/or second conductive layer may be a structured or patterned conductive layer, e.g. including integrated circuitry. It should be mentioned that the forming of the first and/or second conductive layer may of course comprising one or several processing steps, for example forming a (continuous) layer and patterning the same, e.g. etching including (several) deposition, etching, removal steps.

According to an exemplary embodiment the method further comprises forming a second through hole from the first conductive layer to the second conductive layer at a position of the through hole which is at least partially filled with dielectric material and which forms the through via.

In particular, the second through hole may be mechanically drilled or formed via a laser process. For example, the (first) through hole and the second through hole may be coaxially arranged.

According to an exemplary embodiment of the method the through hole which is at least partially filled with dielectric material and which forms the through via has a larger diameter than the second through hole.

In particular, the second through hole may pass through or penetrate through both dielectric layers sandwiching the conductive core layer. Thus, the second through hole may be used for forming an (electrical) connection between first and second (upper and lower) conductive layers. For example, the second through hole may be formed coaxially with the first through hole (or recess) formed for the through via passing through the conductive core layer. Thus, it may be possible that the two through holes (the second through hole and the filled through hole) may be coaxially arranged and that a layer of the dielectric material at least partially filling the through hole remains even after forming the second through hole. Thus, it may be possible that the second through hole may be used for electrically connecting the first and second conductive layers while still being electrically isolated from the metallic core layer.

According to an exemplary embodiment the method further comprises forming at least one blind hole reaching from the first conductive layer to the metallic core.

In particular, the metallic core forms the stop of the blind hole, i.e. the metallic core is not penetrated by the at least one blind hole. For example, the at least one blind hole may be formed by a laser. In particular, the at least one blind hole may be filled or unfilled by a heat conductive material. The blind hole (or a blind via) may in particularly function as a heat bridge or for thermal connecting the first conductive layer and the metallic core. In addition it may as well function as a ground connection in case it is filed by an electrically conductive material and the metallic core forms ground for circuitry integrated in the first conductive layer. It should be noted that of course a plurality of blind holes may be formed. For example, at least one blind hole reaching from the second conductive layer to the metallic core layer may be formed. Thus, also the second conductive layer may be (thermally) connectable to the metallic core.

According to an exemplary embodiment the method further comprises etching the second main surface before forming the second dielectric layer.

In particular, the etching may be a step roughening the second surface, for example, a chemical etching step. Thus, it may be possible to enhance an adhesion of the second dielectric layer, particularly without using a black oxide processing.

Summarizing according to an exemplary embodiment there may be provided a method or process of manufacturing a PCB which does not need any new process steps or materials but may be based on standard materials and process steps. Due to the chosen thickness of the core layer it may be possible to handle the PCB or even semi-finished products during the manufacturing process without too high restrictions, since a sufficient rigidity may be ensured. The PCB comprises two different types of vias, wherein one type is for thermal connection to the core layer, while the other type is for electrical connection from one conductive layer to another conductive layer. The chosen thickness of the core layer as well may provide for a good heat dissipation so that a good thermal performance and a good reliability of the product the PCB is used for or in may be enabled.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawing

The drawing is not necessarily to scale. Instead emphasis is generally being placed upon illustrating the principles of the invention. In the following description, various embodiments are described with reference to the following drawings, in which:
**Fig. 1** schematically illustrates a cross sectional view of a printed circuit board according to an exemplary embodiment;
**Fig. 2** schematically illustrate a detail of the cross sectional view of Fig. 1; and
**Fig. 3A to 3E** schematically illustrates a manufacturing process of a printed circuit board according to an exemplary embodiment.

### Detailed Description

The illustration in the drawing is schematically and not necessarily to scale. It is noted that in different figures, similar or identical elements or features are provided with the same reference signs. In order to avoid unnecessary repetitions elements or features which have already been elucidated with respect to a previously described figure are not elucidated again at a later position of the description.

Further, spatially relative terms, such as "front" and "back", "above" and "below", "left" and "right", et cetera are used to describe an element's relationship to another element(s) as illustrated in the figures. Thus, the spatially relative terms may apply to orientations in use, which differ from the orientation depicted in the figures. Obviously, though, all such spatially relative terms refer to the orientation shown in the figures for ease of description and are not necessarily limiting as an apparatus according to an embodiment of the invention can assume orientations different than those illustrated in the figures when in use.

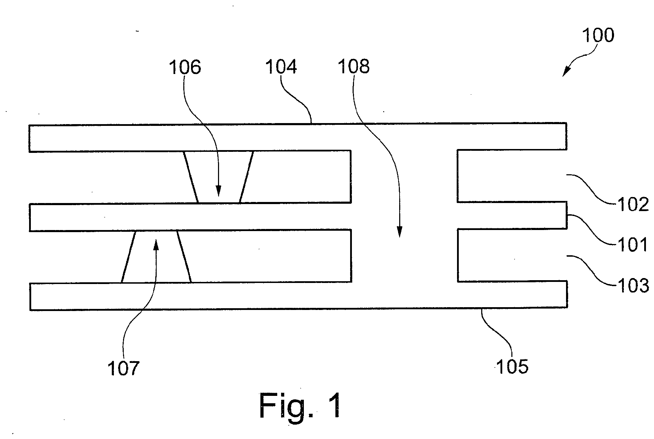

**Fig. 1** schematically illustrates a cross sectional view of a printed circuit board (PCB) 100 according to an exemplary embodiment. In particular, the PCB 100 comprises a central core layer 101, e.g. comprising or consisting of copper, aluminum or another suitable material having a high thermal and/or electrical conductivity, and having a thickness in the range of 75 micrometer to 125 micrometer. The core layer 101 has a plate like structure comprising two main surfaces (upper and lower in Fig. 1) whereon an upper dielectric layer 102 and a lower dielectric layer 103 are formed, e.g. by a lamination process. One or both dielectric layers may comprise or may consist of FR-4 material. Furthermore, the PCB 100 comprises an upper (structured) conductive layer 104 and a lower (structured) conductive layer 105. The conductive layers may have integrated circuits formed thereon or therein.

For thermally connecting the conductive layers 104 and 105 with the core layer 101 blind vias 106 and 107 are formed in the upper and lower dielectric layers, respectively. For example, the blind vias may be formed by using a laser typically resulting in a slightly conical shape as shown in Fig. 1. Preferably the blind vias are filled with heat conductive material in order to provide a good thermal connection to the core layer. However, they may as well be partially or fully unfilled.

For electrically connecting the conductive layers 104 and 105 to each other a through via 108 is formed through the dielectric layers and the core layer. The through via may be formed by forming a through hole at least through the core layer 101. The through hole may be etched or mechanically drilled. In a later step the through hole is at least partially filled with a dielectric material. For example, some of the dielectric material may fill or cover at least the sidewalls of the formed through hole. A (radially) central portion or part of the through hole is still unfilled or void by the dielectric material a conductive material may flow into the void and forms a conductive path through the core layer 101 which is electrically isolated from the core layer 101 by the dielectric material partially filling the through hole. The conductive material forming the conductive path may fully fill the void or may only form a cover layer leaving as well a (radially) central part or portion free of material. As described the dielectric material partially filling the through hole is the same as the dielectric material of at least one of the dielectric layers 102 and 103 and may be filled in a through hole during the forming (e.g. by laminating) of the respective at least one dielectric layer.

It should be noted that of course additional dielectric layer(s) and conductive layer(s) may be formed on upper and lower conductive layers, which as well may be thermally and/or electrically connected with each other and/or the core layer by blind via(s) and/or through via(s). Such additional layer(s) may enable an electronic device having higher integration of circuitry. Furthermore, additional passive and/or electric components may be integrated or embedded in the PCB as well. For example, passive components like resistances, coils, capacitors or the like and/or electronic circuitry like IC chips or dies may be embedded or integrated already into the PCB.

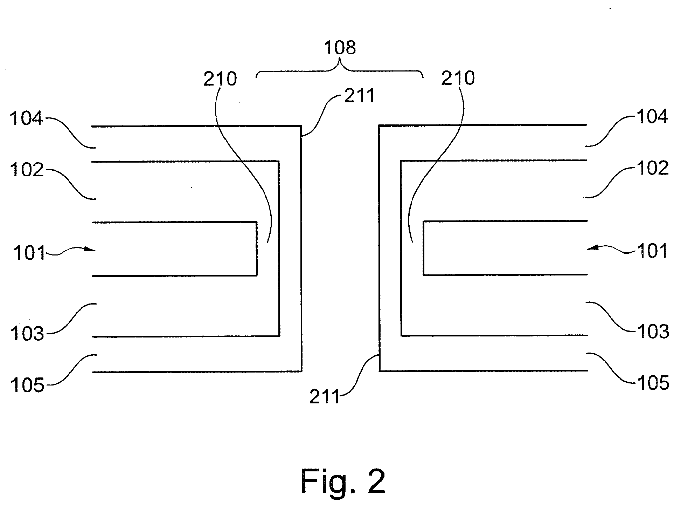

Fig. 2 schematically illustrate a detail of the cross sectional view of Fig. 1. In particular, Fig. 2 shows the through via 108 in an enlarged view. As can be seen in Fig. 2, the through via 108 is formed in a through hole formed in the core layer 101 and the first and second dielectric layers 102 and 103 sandwiching the core layer. However some of the dielectric material of one of the dielectric layers, e.g. the upper dielectric layer 102, forms a cover layer or isolation layer 210 on the core layer 101 electrically isolating the same from a (radially) center portion of the through via 108. For forming an electrically conductive path 211 from the upper conductive layer 104 through the dielectric layers 102 and 103 and the core layer 101 to the lower conductive layer 105. As indicated in Fig. 2 the conductive path is formed by a layer of electrically conductive material, like copper, formed on the dielectric material of the isolation layer 210. The thickness of the conductive path 211 or conductive hole wall may be selected according to the wished electrical resistance. However, it should be noted that the conductive path may as well completely fill the through hole.

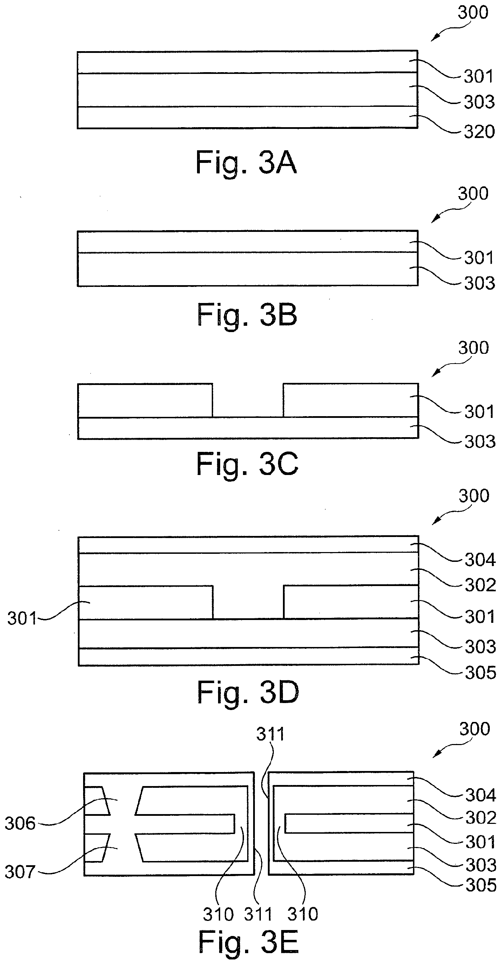

Fig. 3A to 3E schematically illustrates a manufacturing process of a printed circuit board according to an exemplary embodiment. In particular, Fig. 3A shows a commonly used multilayer structure 300 comprising a central dielectric layer 303, e.g. comprising or consisting of an FR-4 material, having attached on main surfaces thereof an upper conductive layer 301 and a lower conductive layer 320. The conductive layers 301 and 320 may comprise or may consist of any suitable conductive material like metal, e.g. copper. A thickness of the conductive layers may be about 100 micrometer.

Fig. 3B shows the multilayer structure 300 of Fig. 3A after removing one of the conductive layers, e.g. the lower conductive layer, so that only the dielectric layer 303 and the conductive layer 301 remain.

Fig. 3C shows the multilayer structure 300 of Fig. 3B after a hole or recess is formed through the conductive layer 301. The through hole may be formed by etching or mechanical or laser drilling.

Fig. 3D shows the multilayer structure 300 of Fig. 3C after a further dielectric layer 302 is formed on the conductive layer 301, which is now a core conductive layer. In additional also on the dielectric layer 303 additional dielectric material may be formed which may be useful for levelling the thicknesses of the dielectric layers 302 and 303. For example the dielectric layers may be formed by applying sheet like dielectric material thereon, which may then subsequently pressed together. It should be noted that core conductive layer 301 may be roughened before the further dielectric layer 302 is formed. During the forming of the further dielectric layer 302 (and/or the forming of the depositing of the additional dielectric material on the lower dielectric layer 303) some dielectric material flows into the through hole formed in the core conductive layer 301.

In particular, the dielectric material flowing into the through hole may completely or only partially fill the through hole. However, at least a layer covering the (in Fig. 3 vertically) sidewalls of the through hole in the region of the conductive core layer 301 forming thereby an isolation layer electrically isolating the conductive core layer 301 from a conductive path formed later in the through hole to form a via electrically connecting the upper side and the lower side of the PBC. Such a via is used to electrically connect an upper (structured) conductive layer 304 and a lower (structured) conductive layer 305.

Fig. 3E shows the multilayer structure 300 of Fig. 3D after process steps for forming the through via and some blind holes. In particular, Fig. 3E shows that a first blind hole 306 is formed in the upper conductive layer 304 and a second blind hole 307 is formed in the lower conductive layer 305. Both blind holes are preferably formed by a laser process, but may be mechanically drilled or etched as well. The blind holes provide thermal coupling of the central core layer 301 with the upper and lower conductive layers 304 and 305, respectively. The blind holes 306 and 307 may be unfilled, partially filled or completely filled with material, e.g. thermally and electrically conductive material and may then function as a ground connection as well.

Furthermore, the above described isolation layer 310 isolating the central core layer 301 from a conductive hole wall 311 of the through via can be seen in Fig. 3E. In addition, a void is schematically shown in Fig. 3E. For forming the conductive hole wall 311 electrically connecting the upper conductive layer 304 and the lower conductive layer 305 a further through hole is formed in the region of the first through hole which is partially filled by the isolation layer 310 was formed beforehand. The further through hole can be mechanically drilled, etched or preferably formed by a laser process. It should be noted that the central void is optional and may be filled as well with an electrically conductive or isolating material depending on the desired resistance value the electrical connection between the two outer conductive layers 304 and 305.

It should further be noted that the (outermost) conductive layers may as well have holes not filled with any material and forming the central portion of the through via(s) or may form complete plate-like or sheet-like layers completely covering the PCB. Furthermore, it should be noted that the further through hole may be formed before forming the upper and lower conductive layers 304 and 305. Thus, it may be possible that the conductive hole wall 311 is formed during the forming of the conductive layers automatically by material of the conductive layers flowing into the further through hole.

It should also be noted that the term "comprising" does not exclude other elements or features and the "a" or "an" does not exclude a plurality. Also elements described in association with different embodiments may be combined. It should also be noted that reference signs shall not be construed as limiting the scope of the claims. While the invention has been particularly shown and described with reference to specific embodiments, it should be understood by those skilled in the art that various changes in form and detail may be made therein without departing from the scope of the invention as defined by the appended claims.

### List of reference signs:

- 100: Printed circuit board
- 101: Core layer
- 102, 103: Dielectric layers
- 104, 105: Conductive layers
- 106, 107: Blind vias
- 108: Through via

## Claims

1. A printed circuit board (100) comprising:
a core layer (101) of a conductive metal having a thickness between 30 micrometer and 120 micrometer,
an upper dielectric layer (102) and a lower dielectric layer (103) sandwiching the core layer,
an upper conductive layer (104) arranged above the upper dielectric layer (102) and a lower conductive layer (105) arranged below the lower dielectric layer (103);
at least one through via (108) passing from the upper conductive layer (104) to the lower conductive layer (105) and filled at least partially with the dielectric material of the upper and/or lower dielectric layer; and
at least one blind via (106), connecting the upper conductive layer (104) with the core layer (101),
wherein the at least one blind via (106) has a diameter in the range of 10 micrometer to 150 micrometer,
wherein the at least one blind via (106) is filled with a thermally conductive material, in particular copper, and
wherein the at least one through via (108) comprises a conductive path through the core layer (101) which is electrically isolated from the core layer (101) by the dielectric material partially filling the through hole (108), and
wherein the upper conductive layer (104) is connected to the at least one through via (108) and to the at least one blind via (106).

2. The printed circuit board (100) according to claim 1, wherein the dielectric material is selected out of the group consisting of:
FR-4 materials;
resin;
bismaleimide triazine resin;
cyanate ester;
glass;
glass fibers;
prepreg materials;
polyimide;
liquid crystal polymers;
epoxy based build-up film;
ceramic material;
Teflon;
metal oxide; and
a combination thereof.

3. The printed circuit board (100) according to claim 1 or 2, wherein a diameter of the at least one through via (108) is below 500 micrometer.

4. The printed circuit board (100) according to any one of the claims 1 to 3, further comprising an upper outer conductive layer and a lower outer conductive layer, wherein the upper outer conductive layer is arranged above the upper conductive layer (104) and the lower outer conductive layer is arranged below the lower conductive layer (105).

5. The printed circuit board (100) according to any one of the claims 1 to 4, wherein in the through via (108) a conductive hole wall is formed by an electrically conductive material surrounded by the filled dielectric material.

6. The printed circuit board (100) according to any one of the claims 1 to 5, wherein the printed circuit board (100) further comprising a second blind via (107) connecting the lower conductive layer (105) with the core layer (101).

7. An electronic component comprising:
a printed circuit board (100) according to any one of the claims 1 to 6; and
an electronic circuitry arranged on the printed circuit board (100).

8. The electronic component according to claim 7, wherein the electronic circuitry forms at least one electronic component which is selected out of the group consisting of:
active electronic component;
passive electronic component;
data storage;
filter;
integrated circuit;
signal processing component;
power management component;
optoelectrical interface;
voltage converter;
cryptographic component;
capacity;
resistance;
sending unit;
receiving unit;
transceiving unit;
electro-mechanical converter;
inductivity;
switch;
microelectromechanical system;
battery;
camera; and
antenna.

9. A method of manufacturing a printed circuit board (100), the method comprising:
providing a metallic core layer (101) having a thickness between 30 micrometer and 120 micrometer and having arranged thereon at least one first dielectric layer (102, 103) on a first main surface of the metallic core layer (101);
forming a through hole through the metallic core layer (101);
forming a second dielectric layer (103, 102) on a second main surface opposite to the upper main surface of the metallic core layer (101);
forming an upper conductive layer (104, 105) on the first dielectric layer (102, 103);
at least partially filling the through hole with material of the second dielectric layer (103, 102) to form a through via (108);
forming at least one blind hole (106, 107) reaching from the upper conductive layer (104, 105) to the metallic core (101),
wherein the at least one blind via (106) has a diameter in the range of 10 micrometer to 150 micrometer,
wherein the at least one blind via (106) is filled with a thermally conductive material, in particular copper, and
wherein the through via (108) comprises a conductive path through the core layer (101) which is electrically isolated from the core layer (101) by the dielectric material partially filling the through hole (108), and
wherein the upper conductive layer (104) is connected to the at least one through via (108) and to the at least one blind via (106).

10. The method according to claim 9, the method further comprising:
forming the metallic core layer (101) having the at least one dielectric layer (102, 103) arranged thereon by removing an auxiliary layer.

11. The method according to claim 9 or 10, the method further comprising:
forming a lower conductive layer (105, 104) on the second dielectric layer (103, 102).

12. The method according to claim 11, further comprising:
forming a second through hole from the upper conductive layer (104, 105) to the lower conductive layer (105, 104) at a position of the through hole which is at least partially filled with dielectric material and which forms the through via.

13. The method according to claim 12, wherein the through hole (108) which is at least partially filled with dielectric material and which forms the through via has a larger diameter than the second through hole.

14. The method according to any one of the claims 9 to 13 further comprising:
etching the second main surface before forming the second dielectric layer (102, 103).

## Patentansprüche

1. Eine Leiterplatte (100) aufweisend:
eine Kernschicht (101) aus einem leitfähigen Metall mit einer Dicke zwischen 30 Mikrometer und 120 Mikrometer,
eine obere dielektrische Schicht (102) und eine untere dielektrische Schicht (103), welche die Kernschicht (101) sandwichartig einfassen,
eine obere leitfähige Schicht (104), angeordnet über der oberen
dielektrischen Schicht (102) und einer unteren leitfähigen Schicht (105), angeordnet unter der unteren dielektrischen Schicht (103);
mindestens ein Durchgangsloch-Via (108), durchgehend von der oberen leitfähigen Schicht (104) zu der unteren leitfähigen Schicht (105) und zumindest teilweise gefüllt mit dem dielektrischen Material der oberen und/oder der unteren dielektrischen Schicht; und
mindestens ein Sackloch-Via (106), welches die obere leitfähige Schicht (104) mit der Kernschicht (101) verbindet,
wobei das mindestens eine Sackloch-Via (106) einen Durchmesser in dem Bereich von 10 Mikrometer bis 150 Mikrometer hat,
wobei das mindestens eine Sackloch-Via (106) mit einem wärmeleitfähigen Material gefüllt ist, insbesondere Kupfer, und
wobei das mindestens eine Durchgangsloch-Via (108) einen leitfähigen Pfad durch die Kernschicht (101) aufweist, welche elektrisch von der Kernschicht (101) isoliert ist durch das dielektrische Material, welches teilweise das Durchgangsloch (108) ausfüllt, und
wobei die obere leitfähige Schicht (104) verbunden ist mit dem mindestens einen Durchgangsloch-Via (108) und mit dem mindestens einen Sackloch-Via (106).

2. Die Leiterplatte (100) gemäß Anspruch 1,
wobei das dielektrische Material ausgewählt ist aus der Gruppe bestehend aus:
FR-4-Materialien;
Harz;
Bismaleimid-Triaziri-Harz;
Cyanatester;
Glas;
Glasfasern;
Prepreg-Materialien;
Polyimide;
Flüssigkristallpolymere;
Epoxy-basierte Aufbaufolie;
Keramikmaterial;
Teflon;
Metalloxide; und
eine Kombination davon.

3. Die Leiterplatte (100) gemäß Ansprüche 1 oder 2,
wobei ein Durchmesser von dem mindestens einem Durchgangsloch-Via (108) unter 500 Mikrometer ist.

4. Die Leiterplatte (100) gemäß einem der Ansprüche 1 bis 3, ferner aufweisend
eine obere äußere leitfähige Schicht und
eine untere äußere leitfähige Schicht, wobei
die obere äußere leitfähige Schicht über der oberen leitfähigen Schicht (104) angeordnet ist und die untere äußere leitfähige Schicht unter der unteren leitfähigen Schicht (105) angeordnet ist.

5. Die Leiterplatte (100) gemäß einem der Ansprüche 1 bis 4,
wobei in dem Durchgangsloch-Via (108) eine leitfähige Lochwand von einem elektrisch leitfähigen Material ausgebildet ist, welches von dem gefüllten dielektrischen Material umgeben ist.

6. Die Leiterplatte (100) gemäß einem der Ansprüche 1 bis 5, wobei die Leiterplatte (100) ferner ein zweites Sackloch-Via (107) aufweist, welches die untere leitfähige Schicht (105) mit der Kernschicht (101) verbindet.

7. Eine elektronische Komponente, aufweisend:
eine Leiterplatte (100) gemäß einem der Ansprüche 1 bis 6; und
einen elektronischen Schaltkreis angeordnet auf der Leiterplatte (100).

8. Die elektronische Komponente gemäß Anspruch 7, wobei der elektronische Schaltkreis mindestens eine elektronische Komponente ausbildet, die gewählt wird aus der Gruppe bestehend aus:
aktive elektronische Komponente;
passive elektronische Komponente;
Datenspeicher;
Filter;
Integrierte Schaltung;
Signalverarbeitungskomponente;
Leistungsmanagement Komponente;
optoelektrische Schnittstelle;
Spannungswandler;
kryptografische Komponente;
Kapazität;
Widerstand;
Sende-Einheit;
Empfangs-Einheit;
Sende-/Empfangseinheit;
elektro-mechanischer Wandler;
Induktivität;
Schalter;
Mikroelektromechanisches System;
Batterie;
Kamera; und
Antenne.

9. Ein Verfahren zum Herstellen einer Leiterplatte (100), das Verfahren aufweisend:
Bereitstellen einer metallischen Kernschicht (101), die eine Dicke zwischen 30 Mikrometer und 120 Mikrometer hat und auf der mindestens eine erste dielektrischen Schicht (102, 103) auf einer ersten Hauptoberfläche der metallischen Kernschicht (101) angeordnet ist;
Ausbilden eines Durchgangsloch-Vias durch die metallische Kernschicht (101);
Ausbilden einer zweiten dielektrischen Schicht (103, 102) auf einer zweiten Hauptoberfläche gegenüber der oberen Hauptoberfläche der metallischen Kernschicht (101);
Ausbilden einer oberen leitfähigen Schicht (104, 105) auf der ersten dielektrischen Schicht (102, 103);
zumindest teilweises Ausfüllen des Durchgangslochs mit Material der zweiten dielektrischen Schicht (103, 102), um ein Durchgangsloch-Via (108) auszubilden;
Ausbilden von zumindest einem Sackloch (106, 107), welches von der oberen leitfähigen Schicht (104, 105) zum metallischen Kern (101) reicht, wobei
das mindestens eine Sackloch-Via (106) einen Durchmesser in dem Bereich von 10 Mikrometer bis 150 Mikrometer hat, wobei
das mindestens eine Sackloch-Via (106) mit einem wärmeleitfähigen Material gefüllt ist, insbesondere Kupfer, und wobei
das Durchgangsloch-Via (108) einen leitfähigen Pfad durch die Kernschicht (101) aufweist, welche elektrisch von der Kernschicht (101) isoliert ist durch das dielektrische Material, weiches teilweise das Durchgangsloch (108) ausfüllt,
wobei die obere leitfähige Schicht (104) mit dem mindestens einen Durchgangsloch-Via (108) und mit dem mindestens einem Sackloch-Via (106) verbunden ist.

10. Das Verfahren gemäß Anspruch 9, das Verfahren ferner aufweisend:
Ausbilden der metallischen Kernschicht (101), welche die mindestens eine dielektrische Schicht (102, 103) darauf angeordnet hat, durch das Entfernen einer Hilfsschicht.

11. Das Verfahren gemäß Anspruch 9 oder 10, das Verfahren ferner aufweisend:
Ausbilden unteren leitfähigen Schicht (105, 104) auf der zweiten dielektrischen Schicht (103, 102).

12. Das Verfahren gemäß Anspruch 11, ferner aufweisend:
Ausbilden eines zweiten Durchgangslochs von der oberen leitfähigen Schicht (104, 105) zur unteren leitfähigen Schicht (105, 104) an einer Position des Durchgangslochs, welches zumindest teilweise mit dielektrischem Material gefüllt ist und welches das Durchgangsloch ausbildet.

13. Das Verfahren gemäß Anspruch 12, wobei das Durchgangsloch (108), welches zumindest teilweise gefüllt ist mit dielektrischem Material und welches das Durchgangsloch-Via ausbildet, einen größeren Durchmesser hat als das zweite Durchgangsloch.

14. Das Verfahren gemäß einem der Ansprüche 9 bis 13, ferner aufweisend: Ätzen der zweiten Hauptoberfläche vor dem Ausbilden der zweiten dielektrischen Schicht (102, 103).

## Revendications

1. Carte de circuit imprimé (100) comprenant :
une couche centrale (101) d'un métal conducteur ayant une épaisseur entre 30 micromètres et 120 micromètres,
une couche diélectrique supérieure (102) et une couche diélectrique inférieure (103) prenant en sandwich la couche centrale,
une couche conductrice supérieure (104) agencée au-dessus de la couche diélectrique supérieure (102) et une couche conductrice inférieure (105) agencée en dessous de la couche diélectrique inférieure (103) ;
au moins un via (108) passant de la couche conductrice supérieure (104) à la couche conductrice inférieure (105) et rempli au moins partiellement avec le matériau diélectrique de la couche diélectrique supérieure et/ou inférieure ; et
au moins un trou borgne (106), connectant la couche conductrice supérieure (104) avec la couche centrale (101),
dans laquelle l'au moins un trou borgne (106) a un diamètre dans la plage de 10 micromètres à 150 micromètres,
dans laquelle l'au moins un trou borgne (106) est rempli avec un matériau thermiquement conducteur, en particulier le cuivre, et
dans laquelle l'au moins un via (108) comprend une piste conductrice à travers la couche centrale (101) qui est isolée électriquement de la couche centrale (101) par le matériau diélectrique remplissant au moins partiellement le trou traversant (108), et
dans laquelle la couche conductrice supérieure (104) est connectée à l'au moins un via (108) et à l'au moins un trou borgne (106).

2. Carte de circuit imprimé (100) selon la revendication 1, dans laquelle le matériau diélectrique est sélectionné à partir du groupe constitué :
de matériaux FR-4 ;
de la résine ;
de la résine bismaléimide triazine ;
d'un ester de cyanate ;
du verre ;
de fibres de verre ;
de matériaux préimprégnés ;
d'un polyimide ;
de polymères à cristaux liquides ;
d'un film d'accumulation à base d'époxy ;
d'un matériau céramique ;
du Téflon ;
d'un oxyde métallique ; et
d'une combinaison de ceux-ci.

3. Carte de circuit imprimé (100) selon la revendication 1 ou 2, dans laquelle un diamètre de l'au moins un via (108) est inférieur à 500 micromètres.

4. Carte de circuit imprimé (100) selon l'une quelconque des revendications 1 à 3, comprenant en outre une couche conductrice externe supérieure et une couche conductrice externe inférieure, dans laquelle la couche conductrice externe supérieure est agencée au-dessus de la couche conductrice supérieure (104) et la couche conductrice externe inférieure est agencée en dessous de la couche conductrice inférieure (105).

5. Carte de circuit imprimé (100) selon l'une quelconque des revendications 1 à 4, dans laquelle dans le via (108) une paroi de trou conducteur est formée par un matériau électriquement conducteur entouré par le matériau diélectrique rempli.

6. Carte de circuit imprimé (100) selon l'une quelconque des revendications 1 à 5, dans laquelle la carte de circuit imprimé (100) comprend en outre un second trou borgne (107) connectant la couche conductrice inférieure (105) avec la couche centrale (101).

7. Composant électrique comprenant :
une carte de circuit imprimé (100) selon l'une quelconque des revendications 1 à 6 ; et
une circuiterie électronique agencée sur la carte de circuit imprimé (100).

8. Composant électronique selon la revendication 7, dans lequel la circuiterie électronique forme au moins un composant électronique qui est sélectionné à partir du groupe constitué :
d'un composant électronique actif ;
d'un composant électronique passif ;
d'un dispositif de stockage de données ;
d'un filtre ;
d'un circuit intégré ;
d'un composant de traitement de signal ;
d'un composant de gestion d'énergie ;
d'une interface opto-électrique ;
d'un convertisseur de tension ;
d'un composant cryptographique ;
d'une capacité ;
d'une résistance ;
d'une unité d'émission ;
d'une unité de réception ;
d'une unité d'émission-réception ;
d'un convertisseur électromécanique ;
d'une inductance ;
d'un commutateur ;
d'un microsystème électromécanique ;
d'une batterie ;
d'une caméra ; et
d'une antenne.

9. Procédé de fabrication d'une carte de circuit imprimé (100), le procédé comprenant :
la fourniture d'une couche centrale métallique (101) ayant une épaisseur entre 30 micromètres et 120 micromètres et ayant, agencée dessus, au moins une première couche diélectrique (102, 103) sur une première surface principale de la couche centrale métallique (101);
la formation d'un trou traversant à travers la couche centrale métallique (101) ;
la formation d'une seconde couche diélectrique (103, 102) sur une seconde surface principale en face de la surface principale supérieure de la couche centrale métallique (101) ;
la formation d'une couche conductrice supérieure (104, 105) sur la première couche diélectrique (102, 103) ;
le remplissage au moins partiel du trou traversant avec un matériau de la seconde couche diélectrique (103, 102) pour former un via (108) ;
la formation d'au moins un trou borgne (106, 107) allant de la couche conductrice supérieure (104, 105) à l'âme métallique (101),
dans lequel l'au moins un trou borgne (106) a un diamètre dans la plage de 10 micromètres à 150 micromètres,
dans lequel l'au moins un trou borgne (106) est rempli avec un matériau thermiquement conducteur, en particulier le cuivre, et
dans lequel le via (108) comprend une piste conductrice à travers la couche centrale (101)qui est isolée électriquement de la couche centrale (101) par le matériau diélectrique remplissant partiellement le trou traversant (108), et
dans lequel la couche conductrice supérieure (104) est connectée à l'au moins un via (108) et à l'au moins un trou borgne (106).

10. Procédé selon la revendication 9, le procédé comprenant en outre :
la formation d'une couche centrale métallique (101) ayant l'au moins une couche diélectrique (102, 103) agencée dessus en enlevant une couche auxiliaire.

11. Procédé selon la revendication 9 ou 10, le procédé comprenant en outre :
la formation d'une couche conductrice inférieure (105, 104) sur la seconde couche diélectrique (103, 102).

12. Procédé selon la revendication 11, comprenant en outre :
la formation d'un second trou traversant de la couche conductrice supérieure (104, 105) à la couche conductrice inférieure (105, 104) au niveau d'une position du trou traversant qui est rempli au moins partiellement avec un matériau diélectrique et qui forme le via.

13. Procédé selon la revendication 12, dans lequel le via (108) qui est rempli au moins partiellement avec un matériau diélectrique et qui forme le via a un diamètre plus grand que le second trou traversant.

14. Procédé selon l'une quelconque des revendications 9 à 13 comprenant en outre :
la gravure de la seconde surface principale avant la formation de la seconde couche diélectrique (102, 103).
